# EUROPEAN PATENT SPECIFICATION

(11) **EP 3 144 591 B1**
(45) Date of publication and mention of the grant of the patent: **20.06.2018**
(21) Application number: 16189209.6
(22) Date of filing: 16.09.2016
(51) Int. Cl.: F21V 23/06, H01L 23/36, F21V 29/74, F21V 29/77, F21V 29/78, F21V 29/83, F21K 9/20, F21Y 115/10, H01L 23/367

(54) **HEAT SINK**
KÜHLKÖRPER
DISSIPATEUR DE CHALEUR

(30) Priority: 18.09.2015 ES 201531335
(43) Date of publication of application: 22.03.2017
(73) Proprietor: Simon, S.A.U., 08030 Barcelona (ES)
(72) Inventor: PLAJA MIRÓ, Salvi, 08013 Barcelona (ES); RIQUÉ REBULL, Adrià, 08013 Barcelona (ES); BATISTE MAYAS, Clara, 08013 Barcelona (ES)
(74) Representative: Carvajal y Urquijo, Isabel

(56) References cited:
- EP-A1- 2 469 160
- EP-A2- 1 467 146
- EP-A2- 1 510 754
- WO-A1-2011/138363
- JP-A- H09 293 410

## Description

### Field of the invention

The present invention relates to a heat sink for electrical or electronic devices in general, and especially for lamps with light-emitting diodes (LED).

### Background of the invention

Heat sinks are used to prevent the aforementioned devices from overheating, transferring the heat produced by the electrical or electronic components that are integrated or connected thereto into the air. The greater the surface area of the heat sink in contact with the air, the greater the heat transfer produced into the air, and therefore, the better the cooling of the apparatus. Other factors that affect the efficiency of heat sinks are the speed of the air, the design, the materials used, carrying out surface treatments, how electrical or electronic equipment are attached to the heat sink, etc.

One of the most frequent designs when making heat sinks is one that shows a configuration of the flaps around an axis. This type of heat sink usually has a central body configured in order to absorb heat dissipated by one or more electrical or electronic components, as well as a plurality of flaps that extend from said central body and are distributed radially around an axis to dissipate the heat absorbed by said central body into the air. In order to favor the absorption of heat of the central body and the transfer thereof to the flaps, materials with high thermal conductivity are usually used, such as aluminum or copper, among others.

These heat sinks usually have geometrically identical flaps that are distributed around the central body according to an established position that is the same for all of them. To facilitate the manufacture of the heat sink through extrusion processes, the heat sink must have a fixed cross section along the extrusion axis. To this end, the walls that make up these flaps are arranged parallel to each other, without there being any tilting between any of the adjacent flaps. In other words, all of the flaps are parallel to each other along the extrusion axis, defining air flow passages with a constant cross section between the flaps.

In general, extrusion processes imply significant machine and maintenance costs, which can be slow when a high thrust pressure of the material is required to make it pass through the die, leave impurities and defects on the surface of the material after extrusion, and present significant geometric limitations since the piece must have a constant cross section along the extrusion axis.

On the other hand, the manufacturing processes through injection molding are more versatile in terms of the variety of shapes and geometries that can be obtained, and they are usually manufactured faster, with lower production costs (depending on the complexity of the piece) and, in general, the pieces obtained have better surface finishes.

Currently, there are considerable difficulties in manufacturing heat sinks through injection molding. The main difficulty lies in the parallel arrangement of the flaps, which are usually all vertical with respect to the axis around which they are distributed. Thus, there is no incline that facilitates the demolding of the heat sink once injection has been carried out. Sometimes, non-uniform variations of flap thickness are used to be able to carry out the demolding. This leads to lower efficiency of the heat sink and higher consumption of raw materials for the manufacture thereof.

The heat sink of the present invention has a configuration that is especially designed to allow its manufacture through injection molding thanks to the presence of the first and second flaps that are arranged in an alternating way, there being tilting between the adjacent, preferably opposite, flaps, according to a vertical plane that is parallel to the axis around which they are distributed. This way, the heat sink provides a profile with tilted flaps of a constant thickness that greatly facilitates its demolding after injection. The resulting heat sink thus presents high functionality and efficiency when dissipating the heat of electrical and electronic devices for which it is intended.

### Description of the invention

The heat sink of the present invention comprises:
- a central body; and
- first and second flaps that extend from the central body and are distributed radially around an axis thereof to dissipate the heat generated by an electric component (lamps, computer boards, electronic devices, etc. or parts thereof: LED, CPU, etc.).

The heat sink of the present invention is characterized in that the first flaps and the second flaps are arranged in an alternating way, there being tilting between the adjacent flaps, according to a first plane that is parallel to the axis of the central body. It has a tilted configuration that, as previously mentioned, facilitates the demolding of the heat sink after the injection process.

Preferably, the first flaps and the second flaps are tilted in opposite directions according to the first plane.

Preferably, the first flaps and second flaps with a constant, or uniform, thickness can be designed with the flaps being tilted, which favors the dissipation of heat and improves the efficiency of the heat sink. The constant thickness can also be subject to possible variations of ±10% its thickness, which is a result of roughness or other manufacturing defects.

The first flaps and the second flaps have first tilt angles between the adjacent flaps according to the first plane, which range between 1° ≤ αV < 180°. Preferably, the first tilt angles (αV) between the adjacent flaps (3a, 3b) according to the first plane (V) ranging between 1° ≤ α_{V} ≤ 45°. At least one of the first flaps and the second flaps can be joined together, or they can all be individually separated, forming a profile that is completely discontinuous around the heat sink. They can also be partially joined, forming groups of flaps that are separated from other groups of flaps. According to the invention the heat sink comprises air flow passages that are delimited between the adjacent flaps. Since the flaps are tilted, said air passages have a variable transverse cross section that causes changes in air speed between them, thus favoring heat transfer.

Preferably, at least one first flap is longitudinally joined to an adjacent second flap at a connection edge. If this is repeated for all of the flaps of the heat sink, the sink will be formed by a plurality of groups of two flaps separated from each other by air flow passages, where each group comprises a first flap and a second flap.

Specifically, said connection edge is used as the pressure area for the removal tool to push the radiator and thus remove it from the mold, something that is not possible when the flaps are parallel or are not tilted. Previously, two different methods could be used, either making the flaps thicker or giving them different thickness variations in the places where the removal tool would be used. Both cases led to losses in heat transfer efficiency and a greater use of material in the flaps.

Preferably, transverse cross sections that are parallel to the axis of the central body and are V-shaped are formed between adjacent flaps.

Preferably, longitudinal cross sections that are perpendicular to the axis of the central body and are V-shaped are formed between adjacent flaps.

To power the electrical or electronic component, the heat sink comprises a terminal block, preferably arranged between the flaps. To this end, the heat sink comprises first flaps and second flaps arranged between the central body and the terminal block.

Among the multiple configurations that this central body could have according to the geometry of the heat sink, said central body preferably comprises an inner hollow space configured to house the electrical component or a part of it.

### Brief description of the drawings

What follows is a very brief description of a series of drawings that aid in better understanding the invention, and which are expressly related to various embodiments of said invention that are presented by way of non-limiting examples of the same.
Figure 1 is an exploded perspective view of an electrical component, in this case a lamp for built-in installations, which incorporates the heat sink of the present invention, in accordance with a first embodiment.
Figure 2 is an elevation view of the heat sink shown in figure 1.
Figure 3 is a plan view of the heat sink shown in Figure 1.
Figure 4 is a sectional view of the heat sink according to the cross-section line A-A shown in Figure 3.
Figure 5 is a perspective view of the heat sink shown in Figure 1.
Figure 6 is a perspective view of the heat sink of the present invention, in accordance with a second embodiment.
Figure 7 is a plan view of the heat sink shown in Figure 6.

### Detailed description of the invention

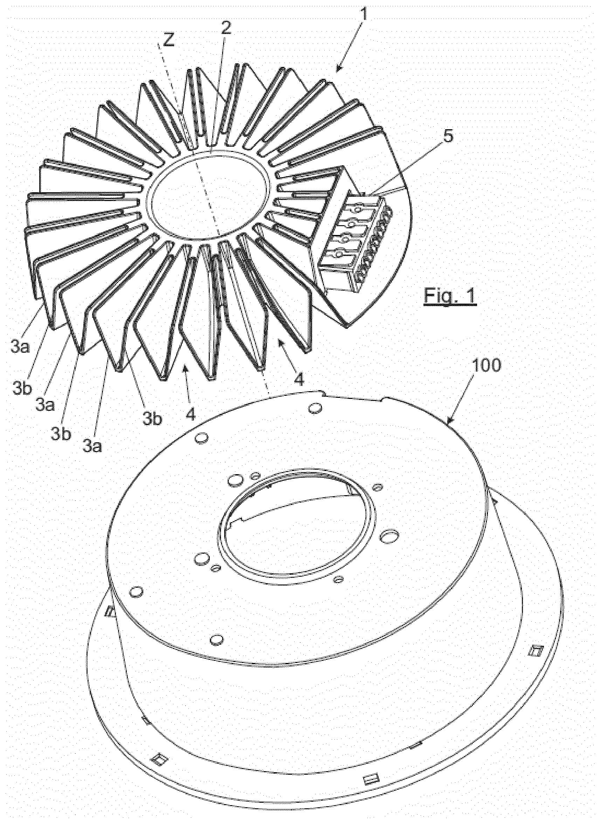

Figure 1 is an exploded perspective view of an electrical component (100), in this case a lamp for built-in installations, which incorporates the heat sink (1) of the present invention.

As can be seen, the heat sink (1) comprises:
- a central body (2); and
- first flaps (3a) and second flaps (3b) that extend from the central body (2) and are distributed around an axis (Z) of the central body (2) to dissipate the heat generated by an electrical component (100).

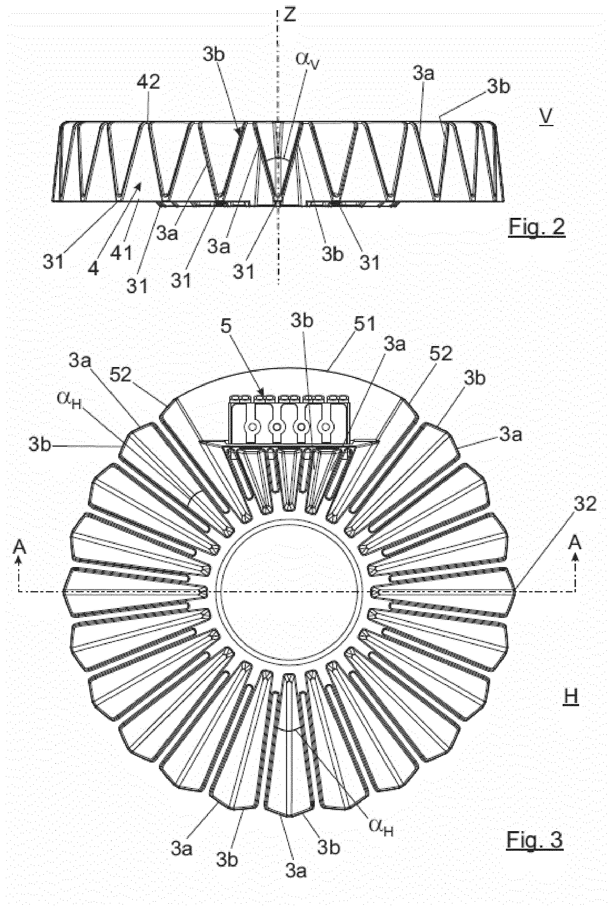

As shown in figure 2, the heat sink (1) is characterized in that the first flaps (3a) and the second flaps (3b) are arranged in an alternating way, there being tilting in opposite directions between the adjacent flaps (3a, 3b) according to a first plane (V) that is parallel to the axis (Z), which form a triangular profile. The first plane (V) being a vertical plane. According to the present example, the flaps (3a, 3b) are distributed radially around the axis (Z), which at the same time corresponds to the axial or central axis of the central body (2).

The first flaps (3a) and the second flaps (3b) have first tilt angles (αV) between the adjacent flaps (3a, 3b) according to the first plane (V) which range between 1° ≤ αV≤ 45°, and according to the present example, are approximately 30°.

The heat sink (1) comprises air flow passages (4) that are delimited between the adjacent flaps (3a, 3b). Each one of these air flow passages (4) has a variable transverse cross section between a wide area (41) and a narrow area (42) between adjacent flaps (3a, 3b), which causes changes in air speed.

The first flaps (3a) are longitudinally joined to the adjacent second flaps (3b) at connection edges (31), forming a plurality of groups of two flaps (3a, 3b) that are separated from each other by air flow passages (4), and where each group comprises a first flap (3a) and a second flap (3b). These connection edges (31) can receive the push of the tool that enables the heat sink (1) to be demolded after the injection process. This way, any mark or sign resulting from this process is left in an area that is less visible.

As shown, transverse cross sections that are parallel to the axis (Z) and are V-shaped are formed between adjacent flaps (3a, 3b).

As shown in figure 3, the first flaps (3a) and the second flaps (3b) are also tilted in opposite directions between the adjacent flaps (3a, 3b) according to a second plane (H) perpendicular to the axis (Z). The second plane (H) being a horizontal plane.

The first flaps (3a) and the second flaps (3b) have second tilt angles (αH) between them according to the second plane (H), which depend on various factors, such as the number of flaps (3a, 3b), the size of the heat sink (1), the value of the first tilt angles (αV), etc. According to the present example, the second tilt angles (αH) have a value of approximately 15°.

As shown, longitudinal cross sections that are perpendicular to the axis (Z) and are V-shaped are formed between adjacent flaps (3a, 3b).

To power the electrical or electronic component (100), the heat sink (1) comprises a terminal block (5). The heat sink (1) comprises first flaps (3a) and second flaps (3b) which are arranged between the central body (2) and the terminal block (5) in order to avoid loss of surface area for heat transfer.

The terminal block (5) is arranged on a support base (51) delimited by two side walls (52) that extend from the central body (2) and are arranged radially around the axis (Z), having first flaps (3a) and second flaps (3b) between both side walls (52).

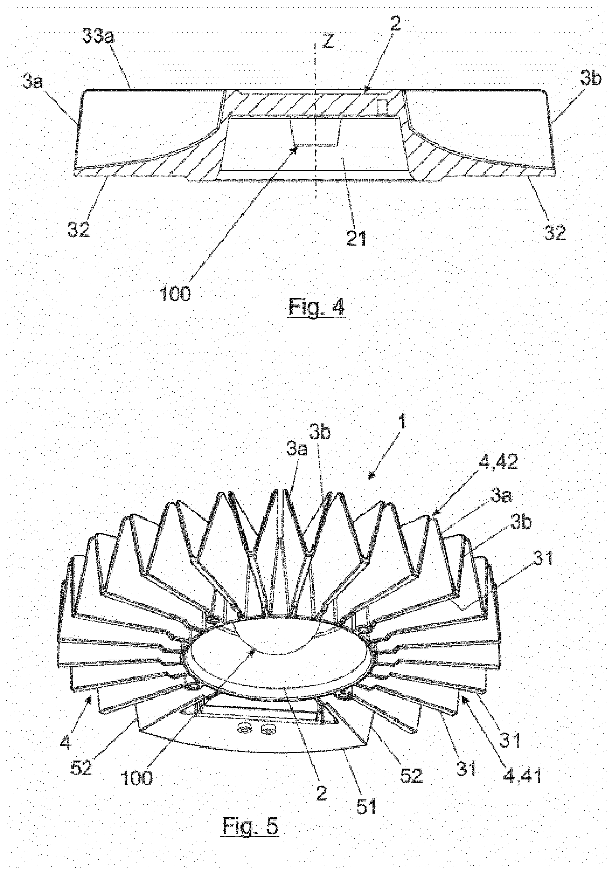

Figures 4 and 5 are sectional and perspective views of the heat sink (1), respectively, in which its geometry can be seen more clearly. As shown, the central body (2) comprises an inner hollow space (21) configured to house the electrical component (100) or a part of it, in this case, being the light-emitting board of the lamp.

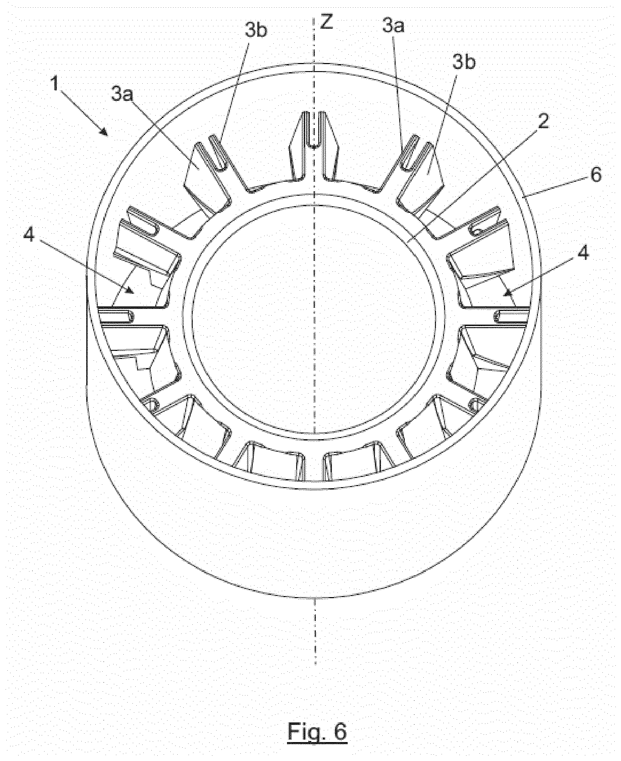

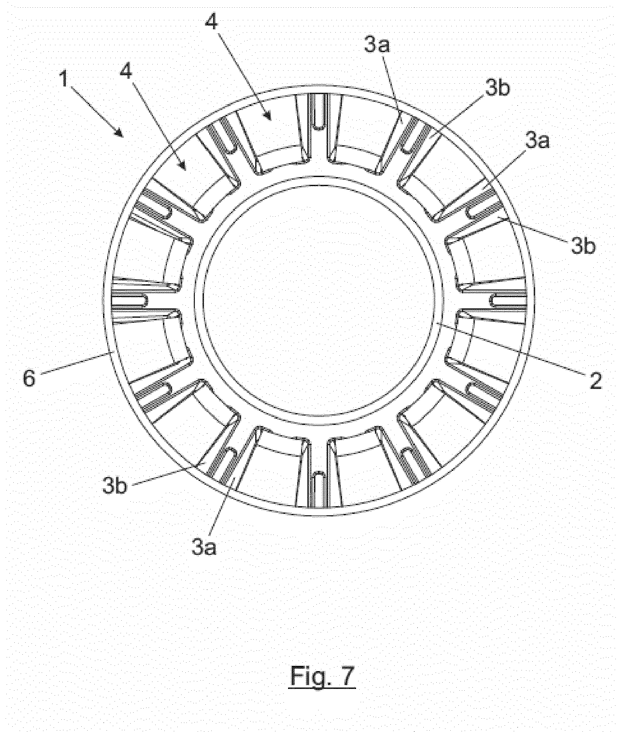

Figures 6 and 7 are perspective and plan views of the heat sink of the present invention, respectively, in accordance with a second embodiment.

As shown, in this case the heat sink (1) is housed inside a cylindrical casing (6) that collects some of the heat of the flaps (3a, 3b) to dissipate it into the air, taking advantage of its greater surface area for heat transfer. Like the previous embodiment, the first flaps (3a) and second flaps (3b) extend from the central body (2) and are distributed around an axis (Z) to dissipate the heat generated by an electrical component (100), which is not represented. Thus, in this exemplary embodiment, the flaps (3a, 3b) resemble connection ribs that link to another heat transfer element, in order to create thermal conduction bridges which favor heat dissipation.

Likewise, the first flaps (3a) and the second flaps (3b) are arranged in an alternating way, there being tilting between the adjacent flaps (3a, 3b) according to a first plane (V) that is parallel to the axis (Z), to enable the heat sink to be demolded after it undergoes the injection manufacturing process.

## Claims

1. A heat sink that comprises:
• a central body (2); and
• first flaps (3a) and second flaps (3b) that extend from the central body (2) and are distributed around an axis (Z) to dissipate the heat generated by an electrical component (100);
wherein the first flaps (3a) and the second flaps (3b) are arranged in an alternating way, there being tilting between the adjacent flaps (3a, 3b) according to a first plane (V) that is parallel to the axis (Z), said heat sink (1) **characterized in that** it comprises air flow passages (4) delimited between adjacent flaps (3a, 3b), having a variable transverse cross section in the direction of the axis (Z) between a wide area (41) and a narrow area (42) between said adjacent flaps (3a, 3b).

2. The heat sink according to claim 1, **characterized in that** the first flaps (3a) and the second flaps (3b) are tilted in opposite directions according to a first plane (V).

3. The heat sink according to any of claims 1 and 2, **characterized in that** the first flaps (3a) and the second flaps (3b) have first tilt angles (αV) between the adjacent flaps (3a, 3b) according to the first plane (V) which range between 1° ≤ αV≤ 45°.

4. The heat sink according to any of the claims 1 to 3, **characterized in that** at least one first flap (3a) is longitudinally joined to an adjacent second flap (3b) at a connection edge (31).

5. The heat sink according to any of the claims 1 to 4, **characterized in that** transverse cross sections that are parallel to the axis (Z) and are V-shaped are formed between adjacent flaps (3a, 3b).

6. The heat sink according to any of claims 1 to 5, **characterized in that** longitudinal cross sections that are perpendicular to the axis (Z) and are V-shaped are formed between adjacent flaps (3a, 3b).

7. The heat sink according to any of claims 1 to 6, **characterized in that** it comprises a terminal block (5) arranged between flaps (3a, 3b) to power the electrical or electronic component (100).

8. The heat sink according to claim 7, **characterized in that** it comprises first flaps (3a) and second flaps (3b) arranged between the central body (2) and the terminal block (5).

9. The heat sink according to any of claims 1 to 8, **characterized in that** the central body (2) comprises an inner hollow space (21) configured to house the electrical component (100).

10. The heat sink according to any of claims 1 to 9, **characterized in that** the first flaps (3a) and the second flaps (3b) have a constant thickness.

## Patentansprüche

1. Kühlkörper, welcher Folgendes umfasst:
• einen zentralen Körper (2); und
• erste Blätter (3a) und zweite Blätter (3b), welche sich von dem zentralen Körper (2) erstrecken und um eine Achse (Z) zum Ableiten der durch einen elektrischen Bestandteil (100) erzeugten Hitze verteilt sind;
wobei die ersten Blätter (3a) und die zweiten Blätter (3b) abwechselnd angeordnet sind, wobei es eine Kippung zwischen den benachbarten Blättern (3a, 3b) gemäß einer ersten Ebene (V), welche parallel zu der Achse (Z) ist, gibt, wobei der Kühlkörper (1) **dadurch gekennzeichnet ist, dass** er zwischen benachbarten Blättern (3a, 3b) begrenzte Luftströmungsdurchgänge (4) umfasst, welche in Richtung der Achse (Z) zwischen einem breiten Bereich (41) und einem engen Bereich (42) zwischen den benachbarten Blättern (3a, 3b) einen variablen Querschnitt aufweisen.

2. Kühlkörper nach Anspruch 1, **dadurch gekennzeichnet, dass** die ersten Blätter (3a) und die zweiten Blätter (3b) in gegenüberliegende Richtungen gemäß einer ersten Ebene (V) gekippt sind.

3. Kühlkörper nach einem der Ansprüche 1 und 2, **dadurch gekennzeichnet, dass** die ersten Blätter (3a) und die zweiten Blätter (3b) zwischen den benachbarten Blättern (3a, 3b) erste Kippwinkel (αV) gemäß der ersten Ebene (V) aufweisen, welche im Bereich zwischen 1° ≤ αV ≤ 45° liegen.

4. Kühlkörper nach einem der Ansprüche 1 bis 3, **dadurch gekennzeichnet, dass** das mindestens eine Blatt (3a) in Längsrichtung mit einem benachbarten zweiten Blatt (3b) an einem Verbindungsrand (31) verbunden ist.

5. Kühlkörper nach einem der Ansprüche 1 bis 4, **dadurch gekennzeichnet, dass** die in Querrichtung verlaufenden Querschnitte, welche parallel zu der Achse (Z) und V-förmig sind, zwischen benachbarten Blättern (3a, 3b) gebildet sind.

6. Kühlkörper nach einem der Ansprüche 1 bis 5, **dadurch gekennzeichnet, dass** die in Längsrichtung verlaufenden Querschnitte, welche senkrecht zu der Achse (Z) und V-förmig sind, zwischen benachbarten Blättern (3a, 3b) gebildet sind.

7. Kühlkörper nach einem der Ansprüche 1 bis 6, **dadurch gekennzeichnet, dass** er einen zwischen den Blättern (3a, 3b) angeordneten Klemmblock (5) zum Antreiben des elektrischen oder elektronischen Bestandteils (100) umfasst.

8. Kühlkörper nach Anspruch 7, **dadurch gekennzeichnet, dass** er erste Blätter (3a) und zweite Blätter (3b), welche zwischen dem zentralen Körper (2) und dem Klemmblock (5) angeordnet sind, umfasst.

9. Kühlkörper nach einem der Ansprüche 1 bis 8, **dadurch gekennzeichnet, dass** der zentrale Körper (2) einen inneren Hohlraum (21), welcher zum Aufnehmen des elektrischen Bestandteils (100) gestaltet ist, umfasst.

10. Kühlkörper nach einem der Ansprüche 1 bis 9, **dadurch gekennzeichnet, dass** die ersten Blätter (3a) und die zweiten Blätter (3b) eine konstante Dicke aufweisen.

## Revendications

1. Puits de chaleur qui comprend :
• un corps central (2) ; et
• des premiers clapets (3a) et des deuxièmes clapets (3b) qui s'étendent du corps central (2) et qui sont répartis autour d'un axe (Z) pour dissiper la chaleur générée par un composant électrique (100) ;
dans lequel les premiers clapets (3a) et les deuxièmes clapets (3b) sont disposés de façon alternante, étant inclinés entre les clapets adjacents (3a, 3b) selon un premier plan (IV) qui est parallèle à l'axe (Z), ledit puits de chaleur (1) **caractérisé en ce qu'**il comprend des passages de flux d'air (4) délimités entre les clapets adjacents (3a, 3b), ayant une section transversale variable dans le sens de l'axe (Z) entre une zone large (41) et une zone étroite (42) entre lesdits clapets adjacents (3a, 3b).

2. Puits de chaleur selon la revendication 1, **caractérisé en ce que** les premiers clapets (3a) et les deuxièmes clapets (3b) sont inclinés dans des sens opposés selon un premier plan (V).

3. Puits de chaleur selon l'une quelconque des revendications 1 et 2, **caractérisé en ce que** les premiers clapets (3a) et les deuxièmes clapets (3a) ont des premiers angles d'inclinaison (αV) entre les clapets adjacents (3a, 3b) selon le premier plan (V) qui sont compris entre 1°≤αV≤45°.

4. Puits de chaleur selon l'une quelconque des revendications 1 à 3, **caractérisé en ce qu'**au moins un premier clapet (3a) est relié longitudinalement à un deuxième clapet adjacent (3b) à un bord de raccordement (31).

5. Puits de chaleur selon l'une quelconque des revendications 1 à 4, **caractérisé en ce que** des sections transversales qui sont parallèles à l'axe (Z) et qui sont en forme de V sont formées entre les clapets adjacents (3a, 3b).

6. Puits de chaleur selon l'une quelconque des revendications 1 à 5, **caractérisé en ce que** des sections transversales longitudinales qui sont perpendiculaires à l'axe (Z) et qui sont en forme de V sont formées entre les clapets adjacents (3a, 3b).

7. Puits de chaleur selon l'une quelconque des revendications 1 à 6, **caractérisé en ce qu'**il comprend un bornier (5) disposé entre les clapets (3a, 3b) pour alimenter le composant électrique ou électronique (100).

8. Puits de chaleur selon la revendication 7, **caractérisé en ce qu'**il comprend des premiers clapets (3a) et des deuxièmes clapets (3b) disposés entre le corps central (2) et le bornier (5).

9. Puits de chaleur selon l'une quelconque des revendications 1 à 8, **caractérisé en ce que** le corps central (2) comprend un espace creux interne (21) configuré pour loger le composant électrique (100).

10. Puits de chaleur selon l'une quelconque des revendications 1 à 9, **caractérisé en ce que** les premiers clapets (3a) et les deuxièmes clapets (3b) ont une épaisseur constante.
